# EUROPEAN PATENT APPLICATION

(11) **EP 0 802 706 A1**
(43) Date of publication of application: **22.10.1997**
(21) Application number: 97302410.2
(22) Date of filing: 08.04.1997
(51) Int. Cl.: H05K 1/11, H05K 3/34

(54) **Uni-pad for suface mount component package**

(30) Priority: 18.04.1996 US 634486
(71) Applicant: LUCENT TECHNOLOGIES INC., Murray Hill, New Jersey 07974-0636 (US)
(72) Inventor: Nikmanesh, Khalil N., Broomfield, Colorado 80020 (US); Smith, Douglas Jay, Thornton, Colorado 80241 (US)
(74) Representative: Johnston, Kenneth Graham

(57) **Abstract**

A uni-pad structure on the surface of a PWB comprising a pair of complimentary pads (20), arranged on an axis, whose dimensions are selected to support the terminals of a plurality of surface mount component sizes. The width (K) of each pad is the width of the widest anticipated surface mount component which may be substituted. A first distance (E), denoting the separation of the inner edges (26) of each pad, is selected as the minimum distance between inner edges (6) of the terminals (4) of the anticipated surface mount components. A second distance (M), denoting the distance between outer edges (28) of the complimentary pads is selected as the maximum distance (L) between outer edges (8) of the terminals (4) of anticipated surface mount components. Manufacturing tolerances may be incorporated into each of these dimensions. A design process is described which considers the dimensions of surface mount components which are likely to be substituted and manufacturing tolerance which may be added to or substracted from the dimensions of the uni-pad.

## Description

### Field of the Invention

This invention relates to electrical component surface mount technology, and in particular to the bonding pads on printed wiring boards which support the components.

### Description of Related Art

The design and use of printed wiring boards, PWBs, is a well known art because it provides for lower labor cost, increased standardization, higher reliability, and greater packing density than hard wired circuitry. Initially, this was a through-hole technology to accommodate pig-tailed discrete components such as resistors, capacitors, inductors, and transistors which were then prevalent and which were designed for hard wiring. The leads emanating from each component were bent, inserted through the holes in the PWB, and soldered to terminal pads on the other side of the PWB. The soldering was by hand or by skimming the lower surface of the PWB over a solder bath. This technology provided tremendous advantages over point-to-point wiring, but it still used a relatively large area because the discrete components were essentially designed for point-to point wiring assembly.

Surface mount technology provided discrete components designed for the automated assembly of PWBs. They were smaller, and, more importantly, their external contacts were made integral with the body of the component. They were a rectangular solid rather than cylindrical, and were specifically made for pick-and-place assembly and reflow soldering. In the assembly process, a solder paste is screened by a squeegee through a stencil, typically stainless steel, which has photolithographically defined holes which correspond to pad areas on the PWB. The solder paste is a mixture of solder particles of predetermined composition and melting point. The particles are contained in a viscous medium of soldering flux, solvent, and viscousifiers or other agents which improve the screening operation and provide a tacky surface onto which the terminals of the surface mount component are set. The components are usually presented in a tape or cartridge and a programmed pick-and-place machine lifts them from their container with a vacuum chuck, orients and aligns them over the correct pads, and places them onto the soldering paste. The viscous flux holds the components in place over the pads which are typically solder coated copper. The terminals on each end of the surface mount component are also solder coated and the flux in the paste dissolves any oxide which may be present and ensures that the solder particles will wet the component terminals and their corresponding pads. This reflow process is done in an oven and the solder is usually a tin-lead alloy, near the eutectic composition, which melts at 183 degrees centigrade. Other alloy compositions can be used to melt at different temperatures which are well known in the art.

Surface mount components are manufactured in a set of standard sizes, and the pads that support their terminals are designed for each particular type and size. Once a design is in production and an inventory of surface mount PWBs is accumulated, any changes in design become very costly and time consuming. These changes occur due to design changes to improve performance or reliability or the need to change suppliers because of availability and price. Changes to reduce cost may be thwarted by the increased cost of redesigning the PWB. Changes for the sake of availability or performance are slowed because new PWBs need to be designed and made. In many cases, the new designs must be re-certified for U.L., CSA, etc.

Accordingly, there is a need in the art of surface mount technology for a PWB with pads that accommodate surface mount components of varying dimensions so that components may be interchanged to take advantage of better price/availability or to improve performance and reliability without the expense, delay and risk to other design areas of PWB redesign and manufacture.

### Summary Of The Invention

The present invention relates to a uni-pad which is a structure on the surface of a PWB comprising a pair of complimentary pads, arranged on an axis, whose dimensions are selected to support the terminals of a plurality of surface mount component sizes. The width of each pad is the width of the widest anticipated surface mount component which may be substituted. A first distance, denoting the separation of the inner edges of each pad, is selected as the minimum distance between inner edges of the terminals of the anticipated surface mount components. A second distance, denoting the distance between outer edges of the complimentary pads is selected as the maximum distance between outer edges of the terminals of anticipated surface mount components. A manufacturing tolerance may be incorporated into each of these dimensions. The most critical of these is the first distance between the inner edges of complimentary pads where a manufacturing tolerance may be subtracted from that distance. For the second distance between the outer edges of the complimentary pads and the width, a manufacturing tolerance may be added. A single uni-pad may thus support surface mount components of varying sizes.

In one embodiment of the invention, a PWB supports at least one uni-pad whose structure and dimensions are described above so that the uni-pad may support varying sizes of surface mount components. The complimentary pads are conductors, typically a metal such as copper which may be solder coated. The PWB may also support metal traces which interconnect the uni-pad to other structures on the PWB.

In another embodiment of the invention, a design process is described which considers the dimensions of surface mount components which are likely to be substituted and manufacturing tolerances which may be added or subtracted from the dimensions of the uni-pad.

The advantage of the uni-pad structure is that a variety of surface mount component sizes may be accommodated by one PWB design to improve the selection of the components for price, availability, function, or reliability. The cost and delay of redesigning and manufacturing a new PWB are avoided.

According to another aspect of the present invention there is provided a printed wiring board adapted to support surface mount components comprising:
at least one uni-pad comprising a pair of complementary pads, arranged on an axis, wherein each pad has a common width, an inner edge, and an outer edge, the distance between the inner edges defining a first distance, the distance between the outer edges defining a second distance, the distance between the inner and outer edges being adapted to support the terminals of a surface mount component; and
at least one electrical trace emanating from the uni-pad, being an electrical conductor adapted to interconnect the uni-pad to other structures supported by the printed wiring board;
wherein the first distance is given by the minimum distance between inner edges of terminals on at least two differently sized surface mount components, the second distance is given by the maximum distance between outer edges of terminals on at least two differently sized surface mount components, and the width is given by the maximum width of terminals on at least two differently sized surface mount components. The width, first distance, and second distance are preferably adjusted to compensate for manufacturing tolerances. The first distance is preferably increased by an empirically determined amount to prevent the lifting of small surface mount components by the surface tension of molten solder.

According to a further aspect of the present invention, there is provided a printed wiring board adapted to support surface mount components of at least two different sizes comprising:
at least one uni-pad comprising a pair of complementary pads, arranged on an axis, wherein each pad has a common width, an inner edge, and an outer edge, the distance between the inner edges defining a first distance, the distance between the outer edges defining a second distance, the distance between the inner and outer edges being adapted to support the terminals of a surface mount component; and
at least one electrical trace emanating from the uni-pad, being an electrical conductor adapted to interconnect the uni-pad to other structures supported by the printed wiring board;
wherein the first distance is given by the minimum distance between inner edges of terminals on at least two differently sized surface mount components, the second distance is given by the maximum distance between outer edges of terminals on at least two differently sized surface mount components, and the width is given by the maximum width of terminals on at least two differently sized surface mount components, and the width and second distance are adjusted to compensate for manufacturing tolerances by adding a tolerance and the first distance is adjusted by subtracting a manufacturing tolerance. The first distance is preferably increased by an empirically determined amount to prevent the lifting of small surface mount components by the surface tension of molten solder.

According to a further aspect of the invention, there is provided a method of designing a uni-pad described herein which supports terminals of at least two surface mount components of different sizes comprising:
finding a minimum distance between inner edges of terminals of said surface mount components for determining a first distance between inner edges of complementary pads of the uni-pad;
finding a maximum distance between outer edges of terminals of said surface mount components for determining a second distance between outer edges of complementary pads of the uni-pad; and
finding a maximum width of the terminals of said surface mount components for determining a width of said complementary pads, said width being orthogonal to the first and second distances. A manufacturing tolerance is preferably added to the width and the second distance, or is preferably subtracted from the first distance. An amount is preferably added to the first distance sufficient to compensate for the surface tension force of molted solder which lifts surface mount components from one of the complementary pads.

According to a further aspect of the invention, there is provided a uni-pad for a printed wiring board to support the terminals of one or more surface mount components and providing interconnecting electrical surfaces cooperating with other structures on said board comprising a pair of complementary pads, wherein each complementary pad has common width, and inner edge, and an outer edge; and the distance between inner and outer edges being adapted to support the terminals of at least one surface mount component.

These and other features and advantages of the invention will be better understood with consideration of the following detailed description of the preferred embodiments.

### Brief Description of the Drawings

Fig. 1 is an isometric view of a typical surface mount component, and
Fig. 2 is a top view of a uni-pad on the surface of a PWB.

### Detailed Description Of The Preferred Embodiments

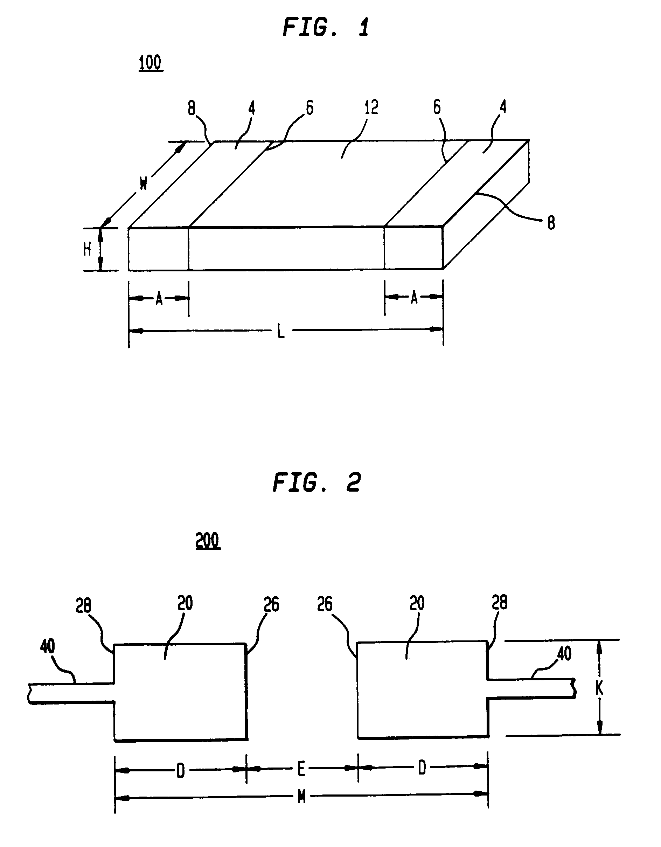

Referring now to Fig. 1. there is shown a typical surface mount component, 100, having a width, W, a height, H, and a length, L. Each end of the surface mount component is comprised of a terminal 4 having inner edge 6 and an outer edge 8. The inner and outer edges of each terminal are separated by a distance, A. The interior of the surface mount component is body 12 which contains a discrete electrical component such as a resistor, capacitor, inductor, or diode. The terminals are metallic conductors and are typically coated with solder, for example a solder of a lead-tin alloy of a specific ratio and melting point.

Referring now to Fig. 2, there is shown a uni-pad, 200, which is a structure comprising a pair of complimentary pads 20, supported by an upper or a lower surface of a PWB. Each pad has an inner edge 26 and an outer edge 28 separated by a distance, D. The inner edges are separated by a distance, E, which is a first distance. The distance between the outer edges, shown as M, is a second distance. The pads function to support a surface mount component. They are typically made of an electrical conductor and they are formed by photolithographic processes which are well known. The conductor may be a noble metal, or alloy thereof, such as gold, palladium, silver or their alloys. The conductor also may be a refractory metal such as titanium or tungsten or silicides thereof. These metals are typical where the PWB substrate is made of a ceramic or silicon. The most common substrate, however, is an organic material which supports a foil of copper which is photolithographically defined to form complimentary pads 20 and other structures such as traces 40 which emanate from each pad 20, and other conductors, pads, terminals, and the like, which are common to PWBs.

The goal of the uni-pad is to accommodate at least two standard sizes of surface mount components having dimensions W, A, and L as shown in Fig. 1. This will provide the advantage of being able to switch components for price, availability, or design changes for performance, upgrades, and reliability without the need to redesign the PWB. This provides a competitive advantage in terms of costs saved and design time. Several conditions must be met to accomplish this: first, the terminals 4 of each surface mount component size which is anticipated as a substitute must be sufficiently supported by the uni-pad to ensure reliable bonding; second, manufacturing tolerances arising form component size, placement, and pad etching dimensions must be considered, especially for the smaller components where the A dimension in Fig. 1 is 15 mils and L is only 60 mils.

To support a plurality of surface mount components of different widths W₁, W₂, ect. the width of the uni-pad, K, must be at least as wide as the widest of these, or W = Kₘₐₓ. Manufacturing tolerances for component dimension, placement, and pad etching may also be added to K. A typical tolerance to accommodate these effects may be 2.5 mils. Similarly, the second distance, M, of the uni-pad should accommodate the longest of the discrete surface mount components having lengths L₁, L₂, ect. so that M = Lₘₐₓ. Again, a manufacturing tolerance may be added to this dimension. The first distance, E, of the uni-pad should be small enough to support each inner edge 6 of the anticipated surface mount components, where the edges are separated by a distance, L-2A. So the first distance is E = [L-2A]ₘᵢₙ. In this case the manufacturing tolerances must be subtracted from the first distance. For small surface mount components, such as those which are only 60 mils long, there is another practical difficulty which is caused by the force of the surface tension of the molten solder which acts to minimize the surface area of the solder causing an effect called "tombstoning" wherein the component is rotated upward from one pad and lifted away from contact with the other pad. The solution is to lessen the contact area below the component, so the dimension E may be increased by 6 mils. This compensation in the design dimensions has been experimentally determined to eliminate "tombstoning" yet provide a reliable bond to the PWB.

The design process for a uni-pad therefore comprises the steps of: selecting a width which is the maximum width of anticipated surface mount components, selecting a first distance which is the minimum of the terminal inner edge distance of the anticipated surface mount components, and selecting a second distance which is the maximum of the terminal outer edges distance of anticipated surface mount components. A manufacturing tolerance to account for dimensional variations in the components, pick-and-place errors, and pad etching errors may be used to adjust each dimension. The adjustment is added to the width and second dimension and subtracted from the first dimension. Further, a compensation in the first distance may be added for the case of small surface mount components to eliminate the effect of "tombstoning".

## Claims

1. An apparatus to facilitate attachment of surface mount components to a printed wiring board comprising:
at least one uni-pad, supported by the printed wiring board, being adapted to support terminals on surface mount components of at least two different sizes.

2. The apparatus of claim 1 wherein the uni-pad is a structure comprising a pair of complementary pads, arranged on an axis, wherein each pad has a common width, an inner edge, and an outer edge, the distance between the inner edges defining a first distance, the distance between the outer edges defining a second distance, the distance between the inner and outer edges being adapted to support the terminals of a surface mount component.

3. The apparatus of claim 1 wherein the uni-pad is comprised of an electrical conductor.

4. The apparatus of claim 3 wherein the uni-pad is solder coated.

5. The apparatus of claim 1 further comprising at least one electrical trace emanating from each complimentary pad.

6. The apparatus of claim 2 wherein the first distance is given by the minimum distance between inner edges of terminals on at least two differently sized surface mount components.

7. The apparatus of claim 2 wherein the second distance is given by the maximum distance between outer edges of terminals on at least two differently sized surface mount components.

8. The apparatus of claim 2 wherein the width is given by the maximum width of terminals on at least two differently sized surface mount components.

9. The apparatus of claim 6 wherein the first distance is increased by an empirically determined amount to prevent the lifting of small surface mount components by the surface tension of molten solder.

10. A printed wiring board adapted to support surface mount components comprising:
at least one uni-pad comprising a pair of complementary pads, arranged on an axis, wherein each pad has a common width, an inner edge, and an outer edge, the distance between the inner edges defining a first distance, the distance between the outer edges defining a second distance, the distance between the inner and outer edges being adapted to support the terminals of a surface mount component; and
at least one electrical trace emanating from the uni-pad, being an electrical conductor adapted to interconnect the uni-pad to other structures supported by the printed wiring board;
wherein the first distance is given by the minimum distance between inner edges of terminals on at least two differently sized surface mount components, the second distance is given by the maximum distance between outer edges of terminals on at least two differently sized surface mount components, and the width is given by the maximum width of terminals on at least two differently sized surface mount components.
